# FASCICULE DE BREVET EUROPEEN

(11) **EP 4 334 753 B1**
(45) Date de publication et mention de la délivrance du brevet: **19.02.2025**
(21) Numéro de dépôt: 22727780.3
(22) Date de dépôt: 03.05.2022
(51) Int. Cl.: G01T 1/02, G01R 31/00

(54) **DISPOSITIF DE MESURE DE DOSE DE RADIATIONS REÇUE PAR RÉFLECTOMÉTRIE OU TRANSFÉROMÉTRIE**
VORRICHTUNG ZUR MESSUNG EINER EMPFANGENEN STRAHLUNGSDOSIS MITTELS REFLEKTOMETRIE ODER TRANSFEROMETRIE
DEVICE FOR MEASURING A RECEIVED RADIATION DOSE THROUGH REFLECTOMETRY OR TRANSFEROMETRY

(30) Priorité: 06.05.2021 FR 2104773
(43) Date de publication de la demande: 13.03.2024
(73) Titulaire: Commissariat à l'Energie Atomique et aux Energies Alternatives, 75015 Paris (FR)
(72) Inventeur: ARMANI, Jean-Marc, 91191 GIF SUR YVETTE CEDEX (FR); COHEN, Josy, 91191 GIF SUR YVETTE CEDEX (FR)
(74) Mandataire: Atout PI Laplace
(86) Numéro de dépôt international: PCT/EP2022/061780
(87) Numéro de publication internationale: WO 2022/233826

(56) Documents cités:
- FR-A1- 2 987 450
- FR-A1- 3 102 562
- SURACI SIMONE VINCENZO ET AL: "In situ defect recognition analysis on long cables through nondestructive reflectometry and dielectric spectroscopy methods: a comparison", 2020 IEEE ELECTRICAL INSULATION CONFERENCE (EIC), IEEE, 22 June 2020 (2020-06-22), pages 41 - 44, XP033805976, DOI: 10.1109/EIC47619.2020.9158583
- ANANDAKUMARAN K ET AL: "Condition Assessment of Cable Insulation Systems in Operating Nuclear Power Plants", IEEE TRANSACTIONS ON DIELECTRICS AND ELECTRICAL INSULATION, IEEE SERVICE CENTER, PISCATAWAY, NJ, US, vol. 6, no. 3, 1 June 1999 (1999-06-01), pages 376 - 384, XP011084298, ISSN: 1070-9878, DOI: 10.1109/94.775626

## Description

L'invention concerne le domaine des installations nucléaires qui sont soumises à des irradiations, plus généralement des agressions radiologiques qui peuvent engendrer des dommages sur les structures. L'invention concerne plus généralement toute application associée à un environnement dans lequel une mesure de dose d'irradiations est d'intérêt, notamment le domaine spatial ou le domaine médical.

L'invention concerne plus précisément la prévention de défaillance d'équipements soumis à des irradiations et porte sur un dispositif de mesure de dose de radiations reçue basé sur le principe de la réflectométrie ou transférométrie.

La connaissance de la dose de radiation absorbée par des équipements soumis à des irradiations est une donnée importante pour la maintenance et la prévention de défaillance de ces équipements. En particulier, dans le domaine des installations nucléaires, la prévention d'un dysfonctionnement d'un équipement est essentielle pour garantir la sécurité des opérateurs.

Les solutions connues permettant de mesurer des doses de radiation sont le plus souvent basées sur des dosimètres actifs ou passifs disposés localement à certains endroits choisis sur les équipements à surveiller ou sur des individus. Ces solutions présentent notamment l'inconvénient de ne pouvoir réaliser des mesures qu'en un nombre de points limités et de nécessiter autant de dispositifs que de points à surveiller. De même les mesures ne peuvent pas être réalisées en continu.

La demande de brevet WO2006/104046 décrit un exemple d'un tel dosimètre pour des applications de radiothérapie.

Par ailleurs, les techniques de réflectométrie ou transférométrie sont connues pour détecter des points chauds ou des variations de température comme cela est proposé dans les demandes de brevet WO 2006/104046 et FR 3042863. Ces techniques consistent à injecter un signal dans un câble et à mesurer le signal réfléchi ou propagé afin de l'analyser et de détecter des discontinuités d'impédance associées à l'impact de ces variations de température sur le câble. La demande de brevet FR 2987450 concerne un procédé de mesure du vieillissement d'au moins un câble électrique et s'applique notamment aux domaines de la réflectométrie et du diagnostic de câbles. Quant à la demande FR 3102562, elle décrit un dispositif de surveillance de l'état d'un câble, plus particulièrement de la dégradation d'un câble basé sur la réflectométrie.

L'invention propose d'utiliser les techniques de réflectométrie ou transférométrie pour concevoir un dispositif de détection de dose de radiation à partir d'un câble.

L'avantage principal d'un tel dispositif est qu'il peut être déployé à l'intérieur d'une installation afin de couvrir une surface plus importante que ce qu'il est possible de couvrir avec des dosimètres classiques. Ainsi, l'invention permet de détecter une dose d'irradiations avec une meilleure résolution spatiale que les solutions de l'art antérieur.

Par ailleurs, l'invention peut être réalisée sous la forme de tissu intelligent qui permet de recouvrir une surface d'un objet pour détecter une dose d'irradiation reçue par cet objet.

L'invention permet ainsi une connaissance en temps réel et à n'importe quel instant choisi du niveau de dose de radiations reçues en un nombre de positions simultanées beaucoup plus important qu'avec des dosimètres classiques.

L'invention a pour objet un dispositif de mesure de dose de radiations reçue comprenant un câble composé d'au moins un matériau sensible à une dose de radiations reçue dans au moins une plage de valeur prédéterminée et un équipement de mesure connecté au câble et configuré pour réaliser une mesure, par réflectométrie ou transférométrie, d'une grandeur physique caractéristique du câble, une base de données comportant un ensemble de couples de valeurs associant une valeur de la grandeur physique à une valeur de dose de radiations reçue et une unité de traitement configurée pour déterminer une mesure de la dose de radiations reçue par le câble à partir de la mesure de la grandeur physique et en interrogeant la base de données. Un tel dispositif est défini dans la revendication 1.

Selon un aspect particulier de l'invention, l'équipement de mesure est configuré pour injecter un signal de test en un point du câble et mesurer ledit signal propagé ou réfléchi en un point du câble et déterminer une mesure de ladite grandeur physique à partir de la mesure du signal.

Selon un aspect particulier de l'invention, la grandeur physique est une amplitude d'un pic de désadaptation mesuré sur le signal ou un coefficient de réflexion ou une impédance caractéristique.

Selon un aspect particulier de l'invention, la grandeur physique est mesurée en une pluralité de points du câble et la mesure de dose de radiations est déterminée pour chacun de ces points.

Selon un aspect particulier de l'invention, l'unité de traitement est configurée pour réaliser une interpolation des valeurs de la base de données à partir de la mesure de la grandeur physique pour en déduire la mesure de dose de radiations.

Selon un aspect particulier de l'invention, la base de données comporte plusieurs jeux de couples de valeurs pour différents types de matériaux et/ou différents types de rayonnements.

Selon un aspect particulier de l'invention, le câble est composé de plusieurs diélectriques séparés par des blindages, chaque diélectrique présentant une sensibilité au rayonnement dans des plages de dose de radiations différentes, l'équipement de mesure étant configuré pour réaliser une mesure de la grandeur physique pour chaque diélectrique.

Selon un aspect particulier de l'invention, le câble présente une structure coaxiale et est composé de plusieurs diélectriques coaxiaux séparés par des blindages.

Selon un aspect particulier de l'invention, le câble présente une structure parallèle et est composé de plusieurs brins coaxiaux étant chacun composé d'une âme centrale, d'un diélectrique et d'un blindage.

Selon un aspect particulier de l'invention, le câble présente une structure parallèle et est composé de plusieurs paires torsadées étant chacune entourée d'un diélectrique et d'un blindage.

Selon un aspect particulier de l'invention, le dispositif comprend en outre une matrice de commutations pour connecter l'équipement de mesure aux différents diélectriques du câble.

L'invention a aussi pour objet un tissu intelligent comprenant un dispositif de mesure de dose de radiations selon l'invention dans lequel le câble est un fil conducteur tissé pour réaliser le tissu.

L'invention, telle que définie dans la revendication 13, a encore pour objet un procédé de calibration d'un dispositif de mesure de dose de radiations selon l'invention comprenant les étapes de :
i. Irradier au moins une portion du câble avec une dose de radiations prédéterminée,
ii. Réaliser une mesure, par réflectométrie ou transférométrie, d'une grandeur physique caractéristique du câble,
iii. Sauvegarder dans une base de données le couple de valeurs de dose de radiations et de grandeur physique associée,
iv. Itérer les étapes précédentes pour différentes doses de radiations.

D'autres caractéristiques et avantages de la présente invention apparaîtront mieux à la lecture de la description qui suit en relation aux dessins annexés suivants.
[Fig. 1] la figure 1 représente un exemple de dispositif de réflectométrie selon l'état de l'art,
[Fig. 2] la figure 2 représente un exemple de réflectogramme temporel obtenu au moyen du dispositif de la figure 1,
[Fig. 3] la figure 3 représente un diagramme temporel illustrant le principe général de la transférométrie,
[Fig. 4] la figure 4 représente un schéma d'un dispositif de détection de dose de radiations selon un mode de réalisation de l'invention,
[Fig. 5] la figure 5 représente plusieurs réflectogrammes temporels obtenus à l'aide d'un dispositif selon l'invention pour caractériser une dose de radiations reçue,
[Fig.6] représente un exemple d'interpolation de valeurs de dose de radiation cumulée en fonction d'une mesure d'impédance caractéristique,
[Fig. 7] représente une première variante de réalisation d'un câble utilisé pour réaliser un dispositif selon l'invention,
[Fig. 8] représente une deuxième variante de réalisation d'un câble utilisé pour réaliser un dispositif selon l'invention,
[Fig. 9] représente une troisième variante de réalisation d'un câble utilisé pour réaliser un dispositif selon l'invention,
[Fig. 10] représente un exemple de réalisation du dispositif selon l'invention.

On rappelle tout d'abord quelques notions relatives aux méthodes de réflectométrie et de transférométrie appliquées à la détection de défauts dans un câble.

Selon un principe connu, les méthodes dites de réflectométrie ou de transférométrie sont utilisées pour détecter et/ou localiser des défauts électriques ou mécaniques qui engendrent des discontinuités ou des ruptures d'impédance dans un câble.

Les méthodes de réflectométrie utilisent un principe proche de celui du radar : un signal électrique, souvent de haute fréquence ou large bande, est injecté en un ou plusieurs endroits du câble à tester. Le signal se propage dans le câble ou le réseau et renvoie une partie de son énergie lorsqu'il rencontre une discontinuité électrique. Une discontinuité électrique peut résulter, par exemple, d'un branchement, de la fin du câble ou plus généralement d'une rupture des conditions de propagation du signal dans le câble. Elle résulte le plus souvent d'un défaut qui modifie localement l'impédance caractéristique du câble en provoquant une discontinuité dans ses paramètres linéiques.

L'analyse des signaux renvoyés au point d'injection permet d'en déduire des informations sur la présence et la localisation de ces discontinuités, donc des défauts éventuels. Une analyse dans le domaine temporel ou fréquentiel est habituellement réalisée. Ces méthodes sont désignées par les acronymes TDR venant de l'expression anglo-saxonne « Time Domain Reflectometry » et FDR venant de l'expression anglo-saxonne « Frequency Domain Reflectometry ».

Ces méthodes sont généralement utilisées pour détecter et localiser des dégradations locales du câble, par exemple des dégradations impactant la gaine du câble.

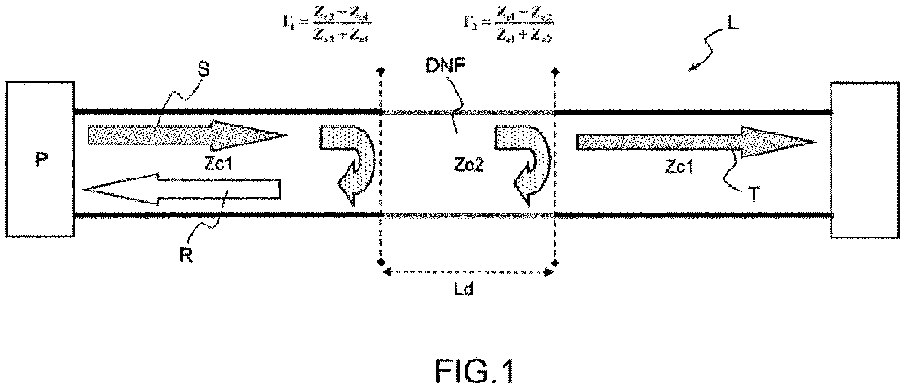

La figure 1 schématise, pour rappel, le principe de fonctionnement d'une méthode de diagnostic par réflectométrie appliquée à une ligne de transmission L présentant un défaut DNF, par exemple un défaut non franc. L'exemple décrit ci-dessous correspond à une méthode de réflectométrie temporelle.

Un signal de référence S, nommé également signal incident, est injecté dans la ligne de transmission en un point P. Le signal réfléchi R est mesuré au même point P (ou en un autre point de la ligne). Ce signal se propage dans la ligne et rencontre, au cours de sa propagation, une première discontinuité d'impédance à l'entrée du défaut DNF. Le signal se réfléchit sur cette discontinuité avec un coefficient de réflexion Γ₁. Si l'impédance caractéristique *Z*_{*c*2} dans la zone du défaut non franc DNF est inférieure à l'impédance caractéristique *Z*_{*c*1} avant l'apparition du défaut, alors le coefficient de réflexion Γ₁ est négatif et se traduit par un pic d'amplitude négative dans le signal réfléchi R. Dans le cas inverse, le coefficient de réflexion Γ₁ est positif et se traduit par un pic d'amplitude positive dans le signal réfléchi R.

La partie transmise du signal incident S continue de se propager dans la ligne au-delà du défaut (partie T sur la figure 1) et rencontre ensuite une deuxième discontinuité d'impédance créant une deuxième réflexion du signal incident avec un coefficient de réflexion Γ₂ de signe opposé au premier coefficient de réflexion Γ₁. Si Γ₁ < 0 alors Γ₂ > 0. Si Γ₁ > 0 alors Γ₂ < 0.

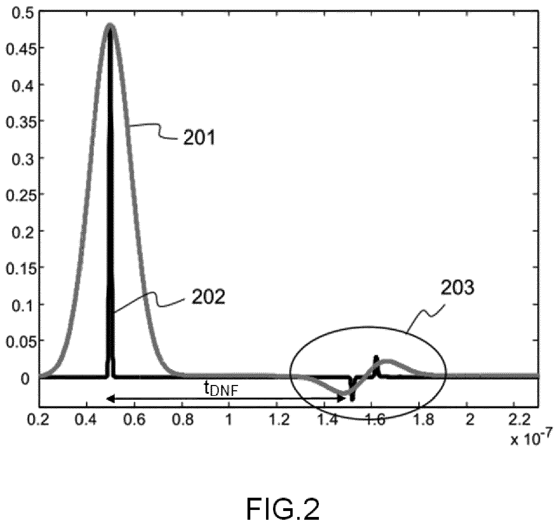

Ainsi, en observant le signal réfléchi R, la signature du défaut non franc DNF est caractérisée par deux pics successifs de signes inversés comme le montre la figure 2.

La figure 2 représente un réflectogramme temporel qui correspond soit directement à la mesure du signal réfléchi R, soit à l'intercorrélation entre le signal réfléchi R et le signal injecté dans le câble S.

Dans le cas où le signal de référence injecté est une impulsion temporelle, ce qui correspond au cas d'une méthode de réflectométrie temporelle, le réflectogramme peut correspondre directement à la mesure du signal réfléchi R. Dans le cas où le signal de référence injecté est un signal plus complexe, par exemple pour des méthodes de type MCTDR (Multi Carrier Time Domain Reflectometry) ou OMTDR (Orthogonal Multi tone Time Domain Reflectometry), alors le réflectogramme est obtenu en inter-corrélant le signal réfléchi R et le signal injecté S.

Sur la figure 2, on a représenté deux réflectogrammes 201, 202 correspondants à deux durées d'impulsion différentes pour le signal injecté dans le câble ou autrement dit à deux fréquences différentes. La courbe 201 correspond à une durée d'impulsion 2.ΔT très supérieure au temps de traversée, par le signal, du défaut non franc DNF. La longueur du défaut étant notée Ld, cette durée vaut Ld/V, avec V la vitesse de propagation du signal dans le câble. La courbe 202 correspond à une durée d'impulsion 2.ΔT très inférieure au temps de traversée, par le signal, du défaut non franc DNF.

Dans les deux cas, la signature 203 du défaut non franc, dans le réflectogramme, est toujours composée de la succession d'un premier pic et d'un second pic dont les signes sont inversés.

La distance entre les deux pics représente la longueur du défaut non franc et leur amplitude représente la sévérité du défaut non franc. En effet, plus la variation de l'impédance caractéristique est importante, plus l'amplitude de la signature du défaut non franc dans le réflectogramme est également importante.

Plus la fréquence du signal est élevée, plus la précision sur l'estimation de la longueur du défaut est importante comme cela peut être identifié sur la figure 2.

Comme cela est connu dans le domaine des méthodes de diagnostic par réflectométrie, la position d_{DNF} du défaut non franc sur le câble, autrement dit sa distance au point P d'injection du signal, peut être directement obtenue à partir de la mesure, sur le réflectogramme temporel de la figure 2, de la durée t_{DNF} entre le premier pic d'amplitude relevé sur le réflectogramme (à l'abscisse 0,5 sur l'exemple de la figure 2) et le pic d'amplitude 203 correspondant à la signature du défaut non franc.

Différentes méthodes connues sont envisageables pour déterminer la position d_{DNF}. Une première méthode consiste à appliquer la relation liant distance et temps : d_{DNF} = V.t_{DNF}/2 où V est la vitesse de propagation du signal dans le câble. Une autre méthode possible consiste à appliquer une relation de proportionnalité du type d_{DNF}/ t_{DNF} = L/t₀ où L est la longueur du câble et t₀ est la durée, mesurée sur le réflectogramme, entre le pic d'amplitude correspondant à la discontinuité d'impédance au point d'injection et le pic d'amplitude correspondant à la réflexion du signal sur l'extrémité du câble.

Les méthodes de transférométrie exploitent non pas la partie du signal réfléchie sur une discontinuité d'impédance mais la partie du signal transmise après cette discontinuité d'impédance. Ainsi, un test de transférométrie consiste à effectuer une mesure du signal propagé en un autre point du câble, distant du point d'injection du signal. Par exemple, la mesure est réalisée à l'extrémité opposée du câble par rapport à l'injection du signal.

Un test de transférométrie consiste à comparer la mesure réalisée à une référence obtenue à un instant précédent, par exemple correspondant à un état neuf ou sain du câble.

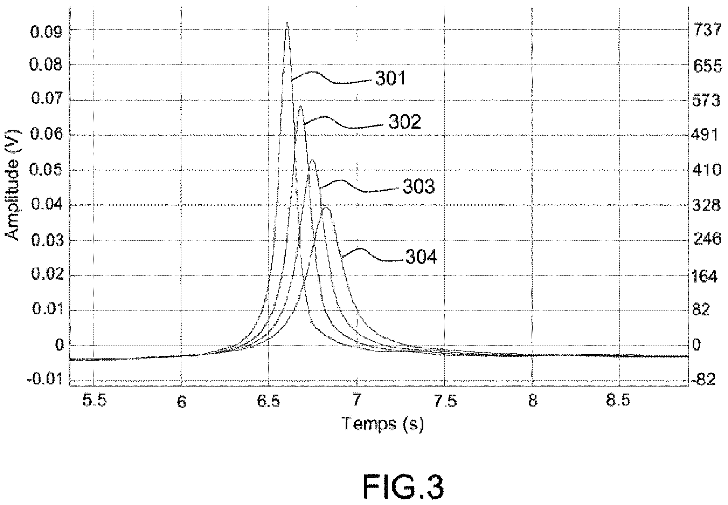

La figure 3 représente, sur un diagramme, un exemple de signaux mesurés après leur propagation entre deux dispositifs points distants d'un câble. Le signal injecté est un créneau temporel. Le signal 301 correspond à une référence obtenue pour un état sain ou non dégradé du câble. Les signaux 302, 303, 304 sont obtenus pour différents niveaux de dégradation du câble.

Un test de transférométrie consiste, par exemple, à calculer la différence entre le maximum du pic du signal obtenu respectivement pour la mesure courante et pour la référence. Comme on peut le voir sur la figure 3, plus le câble est dégradé, plus le pic de signal est atténué. Le test de transférométrie peut prendre en compte d'autres caractéristiques du signal, comme la largeur du pic à un niveau d'amplitude donné, ou d'autres critères plus complexes. La comparaison est basée en particulier sur l'atténuation ou la dispersion du signal. Dans tous les cas, un objectif du test de transférométrie est de comparer la forme des signaux obtenus à deux instants différents afin de détecter une dégradation du câble entre ces deux instants. La méthode de comparaison est par exemple basée sur une méthode des moindres carrés ou sur une corrélation entre les deux signaux afin d'évaluer les différences ou les ressemblances entre les deux mesures. La mesure de référence 301 peut aussi être obtenue par simulation à partir d'une modélisation des paramètres du câble.

Les méthodes de réflectométrie et transférométrie sont généralement utilisées dans le but de détecter des défauts liés à des dégradations locales sur un câble.

La présente invention propose d'utiliser ces méthodes pour concevoir un nouveau dispositif de mesure de dose de radiations reçues.

L'impact de l'irradiation sur les isolants utilisés pour réaliser des câbles est connu et décrit notamment dans les publications [1], [2] et [3]. Cet impact se traduit par un vieillissement radio-induit qui dépend du matériau (diélectrique) utilisé pour fabriquer le câble. Selon le matériau choisi, sa sensibilité aux radiations diffère. En effet, certains matériaux sont sensibles à une très faible dose de radiation cumulée tandis que d'autres sont résistants jusqu'à une dose plus élevée. La dose maximum supportable avant l'apparition d'un court-circuit est également dépendante des propriétés physiques du matériau.

Dans les installations que l'on souhaite protéger des rayonnements (par exemple les centrales nucléaires), les câbles électriques sont généralement conçus avec les matériaux les plus résistants aux radiations afin de limiter le plus possible leur vieillissement en fonction de la dose de radiations cumulée.

L'invention propose au contraire de concevoir un dispositif de détection de dose de radiations à partir d'un câble conçu à l'aide de matériau sensible aux rayonnements afin de pouvoir caractériser le niveau de dose reçue.

Pour cela, il est proposé d'utiliser les techniques de réflectométrie et transférométrie pour détecter des discontinuités d'impédance qui impactent le câble du fait de son exposition aux rayonnements. En effet, certains paramètres physiques d'un câble sont directement impactés par les radiations et peuvent générer une discontinuité d'impédance de la même façon qu'une dégradation physique.

Cela est notamment évoqué dans les publications [4] et [5] qui décrivent l'impact de rayonnements gamma sur les paramètres physiques d'un câble, en particulier sur la permittivité réelle et complexe.

La réflectométrie (ou transférométrie) permet de caractériser un câble par ses paramètres RLCG. Or la permittivité intervient dans la définition de ces paramètres, en particuliers C et G mais également à travers la définition de l'impédance caractéristique et la célérité de l'onde se propageant dans le câble, mais aussi plus généralement dans la définition de tout paramètre physique dépendant de C et G comme la tangente delta ou l'atténuation.

Ainsi, une irradiation du câble a un effet direct sur un réflectogramme (ou transférogramme) en ce qu'elle induit une modification locale de l'impédance caractéristique du câble ou de tout autre paramètre dépendant de C et G.

A partir de cette constatation, l'invention propose de concevoir un dispositif ayant pour fonction de caractériser la dose de radiations reçue par un câble disposé dans un environnement soumis à des rayonnements, en réalisant une mesure par réflectométrie ou transférométrie sur le câble.

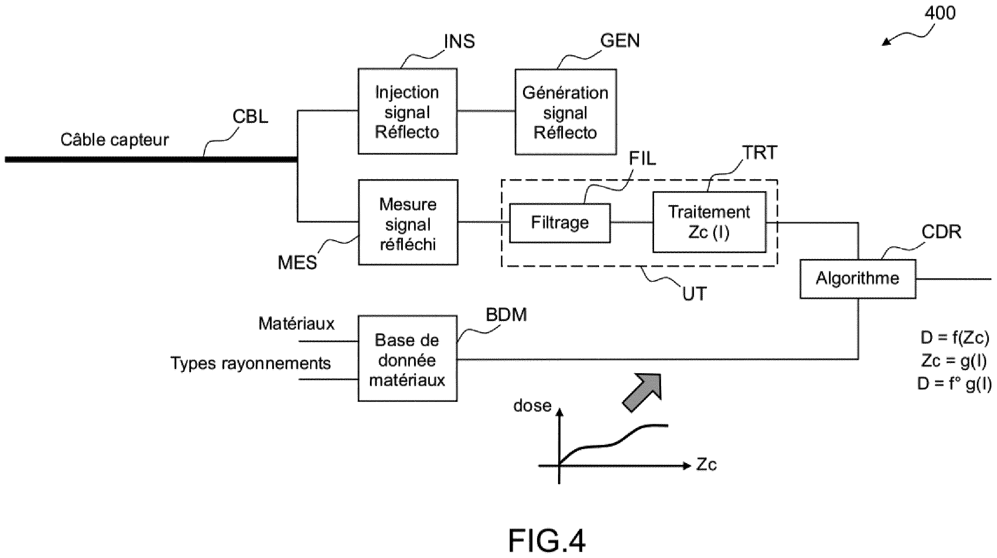

La figure 4 représente un schéma général d'un dispositif selon l'invention.

Il comporte un câble CBL conçu dans au moins un matériau sensible aux radiations. Des exemples d'un tel câble seront décrits plus en détail par la suite. Le dispositif 400 selon l'invention comporte les équipements nécessaires pour réaliser un test de réflectométrie ou un test de transférométrie. Autrement dit, il comporte un générateur GEN de signal de référence et un équipement INJ d'injection du signal de référence en un premier point du câble (par exemple une extrémité). L'équipement d'injection INJ comporte notamment un convertisseur numérique analogique et un coupleur. Le dispositif comporte également un équipement MES de mesure du signal réfléchi ou propagé dans le câble, apte à réaliser une mesure au même point d'injection du câble ou en un autre point (par exemple l'extrémité opposée du câble). L'équipement de mesure MES comporte notamment un coupleur pour acquérir la mesure et un convertisseur analogique numérique pour numériser la mesure.

Le coupleur peut être un coupleur directionnel à effet capacitif ou inductif ou encore une connexion galvanique. Le coupleur peut être réalisé par des connecteurs physiques qui relient le générateur de signal au câble ou par des moyens sans contact, par exemple en utilisant un cylindre métallique dont le diamètre interne est sensiblement égal au diamètre externe du câble et qui produit un effet de couplage capacitif avec le câble.

Le dispositif 400 comporte encore une unité de traitement UT configuré pour générer un réflectogramme temporel ou un diagramme temporel caractéristique d'une mesure de transférométrie. Par exemple l'unité de traitement comporte un module de filtrage FIL et un module de traitement TR pour générer une grandeur physique caractéristique de la mesure en fonction de la position sur le câble. Par exemple, cette grandeur physique correspond à un coefficient de réflexion du signal en un point du câble ou à une impédance caractéristique en un point du câble ou simplement à l'amplitude du signal mesuré par l'équipement de mesure MES calculée sur un pic choisi caractéristique d'une discontinuité d'impédance.

Le dispositif 400 comporte encore une base de données BDM dans laquelle sont sauvegardées des couples de référence associant d'une part une valeur de dose de radiations cumulées et d'autre part une valeur de la grandeur physique mesurée ou calculée par l'unité de traitement UT. Ces couples de référence sont sauvegardées pour une pluralité de valeurs de dose cumulée et, par exemple, pour différents types de rayonnements susceptibles d'impacter le câble mais aussi pour différents types de matériau dont est composé le câble. Les matériaux sont par exemples, des polymères de types différents parmi notamment l'Ethylène Propylene, l'Ethylene Vinyl Acetate, le Polyvinyl Chloride, le Polytétrafluoroéthylène ou le Polyethylene.

Les rayonnements sont par exemple du type, gamma ou beta, il peut s'agir de neutrons ou tout autre type de radiations susceptible de sensiblement modifier les paramètres électriques du câble.

Les informations contenues dans la base de données BDM peuvent être obtenues via une phase de calibration qui sera décrite en détail plus loin. Elles permettent de construire une courbe 401 de la dose cumulée de radiations en fonction de la grandeur physique caractéristique d'une discontinuité d'impédance sur le câble, par exemple une impédance caractéristique.

Alternativement, les informations contenues dans la base de données BDM peuvent être obtenues à partir d'un modèle théorique d'évolution de la dose cumulée de radiations en fonction de la grandeur physique.

Le dispositif 400 selon l'invention comporte encore un module de calcul de la dose de radiations reçue CDR par le câble CBL en un point donné en fonction de la mesure fournie par l'unité de traitement UT et des informations contenues dans la base de données BDM.

Ce module CDR est par exemple implémenté dans l'unité de traitement UT ou dans une unité de calcul séparée apte à être interfacée avec l'unité de traitement UT et la base de données BDM.

La valeur de dose cumulée de radiations calculée par le module CDR peut être fournie à un afficheur ou toute autre interface homme machine.

La valeur de dose cumulée de radiations est, par exemple, calculée en réalisant une interpolation des valeurs contenues dans la base de données BDM à partir de la valeur fournie par l'unité de traitement UT.

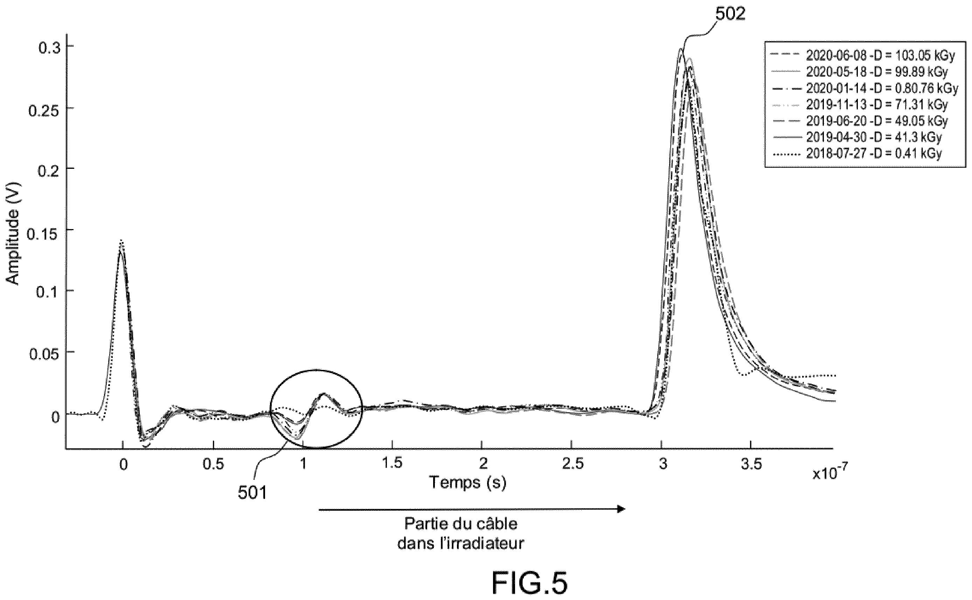

La figure 5 représente un exemple de réflectogrammes temporels obtenus en irradiant un câble sur une zone Z, par exemple en plaçant une portion de ce câble dans un irradiateur. Les différentes courbes sont obtenues pour différentes valeurs de dose de rayonnements Gamma reçues par le câble. Dans cet exemple, le câble est constitué d'une paire torsadée gainée et écrantée avec un isolant en Ethylène-acétate de vinyle (EVA).

Les courbes de la figure 5 sont obtenues en réalisant des mesures de réflectométrie temporelle. L'impact du rayonnement Gamma est observable via les pics 501 et 502 correspondant respectivement au début et à la fin de la zone irradiée.

Ces pics correspondent à des discontinuités d'impédance générées par l'irradiation. L'amplitude des pics 501, 502 dépend directement de la dose de radiations reçue.

Ainsi, en analysant ces réflectogrammes il est possible d'en déduire une estimation de la dose de radiations reçue.

Plus précisément, on détermine, à partir des réflectogrammes mesurés, une grandeur physique caractéristique de la discontinuité d'impédance engendrée localement par le rayonnement. Cette grandeur physique peut être directement l'amplitude du pic 501 ou du pic 502 mesurée en fonction de la position de cette discontinuité sur le câble.

La grandeur physique peut aussi être une impédance caractéristique obtenue à partir du réflectogramme par exemple en appliquant les enseignements de la demande de brevet français du Demandeur N°3025320 ou de la demande de brevet français N° 3034203 ou de toute autre méthode adaptée.

Plus généralement, toute grandeur physique dérivable à partir d'un réflectogramme ou d'une mesure obtenue par transférométrie peut être utilisée.

La base de données BDM est générée à l'avance via un procédé de calibration qui consiste à irradier une zone d'un câble identique au câble CBL pour plusieurs valeurs de dose de radiation et pour différents types de rayonnements et à mesurer à chaque fois la grandeur physique précitée à partir d'une mesure de réflectométrie ou de transférométrie réalisée sur le câble.

Ce procédé de calibration peut être réalisé pour différents types de câbles conçus avec différents matériaux.

Lorsque le dispositif 400 selon l'invention est utilisé en tant que capteur de dose de radiations, le module de calcul de dose de radiations CDR réalise une interpolation des valeurs de la base de données BDM à partir de la mesure fournie par le module de traitement TR.

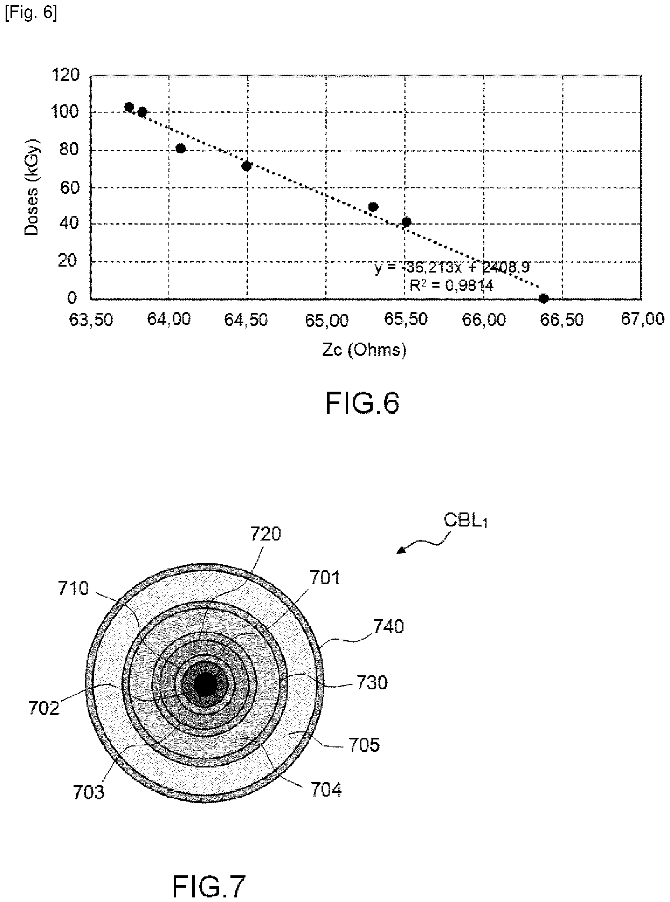

La figure 6 représente un exemple d'interpolation réalisée par le module CDR.

La figure 6 représente différentes valeurs de doses de radiation en fonction d'une impédance caractéristique Zc, correspondant aux couples de valeurs sauvegardés dans la base de données. A partir de ces points, on réalise une interpolation linéaire pour obtenir, pour toute valeur de l'impédance caractéristique Zc, la valeur correspondante de la dose.

Plus généralement, l'interpolation n'est pas forcément linéaire, elle peut être polynomiale ou réalisée à l'aide d'une fonction d'interpolation plus complexe. L'interpolation choisie dépend notamment du type de matériau dans lequel est réalisé le câble et de sa sensibilité aux rayonnements.

La dose de radiations est calculée par le module CDR en appliquant la fonction interpolée à la valeur fournie par le module de traitement TR.

La dose de radiations reçue peut être calculée en différents points du câble.

Différents modes de réalisation d'architecture de câble CBL sont possibles. Selon une première variante de réalisation, le câble CBL est un câble simple qui présente un seul chemin possible pour l'aller et le retour du courant électrique. Par exemple il s'agit d'un câble coaxial standard ou d'un câble à une paire torsadée. Cependant, un inconvénient de ce type de câble est qu'il n'est basé que sur un seul matériau diélectrique ce qui limite potentiellement le domaine de mesure de la dose de radiations reçue. En effet, chaque matériau diélectrique est sensible à un type de rayonnement dans une plage de valeurs prédéterminée.

Afin d'étendre la plage de mesures, d'autres modes de réalisation sont envisagés avec des structures de câble plus complexes. L'idée commune à tous ces modes de réalisation est l'utilisation d'une série de matériaux choisis pour présenter une bonne sensibilité vis-à-vis de la dose croissante de rayonnement, comme par exemple différents diélectriques. On peut ainsi obtenir plus facilement un câble utilisable dans une large plage de doses cumulées, ce qui serait difficile, voire impossible avec un seul type de matériau.

Chaque diélectrique est optimisé pour présenter une bonne sensibilité dans une gamme de dose cumulée et envers un type de rayonnement radiatif donné. En choisissant judicieusement les matériaux, on peut ainsi avoir des gammes de doses qui se complètent pour avoir au final une large plage couverte.

Les figures 7, 8 et 9 décrivent trois modes de réalisation particuliers d'architecture de câble CBL. Ces trois architectures ont pour point commun de comporter plusieurs diélectriques différents, chaque diélectrique ayant une sensibilité aux rayonnements dans des plages de valeurs différentes.

Un avantage de ces architectures particulières est qu'elles permettent de réaliser un câble ayant une sensibilité aux doses de radiations cumulées dans une large plage de valeur, ce qui est plus difficile à obtenir avec un seul matériau.

La figure 7 illustre la section d'un câble CBL₁ de structure coaxiale composé d'une âme centrale 701 et entourée par plusieurs diélectriques différents 702, 703, 704, 705 séparés entre eux par des blindages 710, 720, 730, 740.

Avantageusement, les différents diélectriques sont choisis de sorte que chacun des diélectriques présente une sensibilité aux rayonnements dans une plage de valeurs différentes. Par exemple, les différents diélectriques sont conçus en choisissant un isolant de base et en augmentant son taux d'antioxydant de manière progressive pour concevoir chaque couche de diélectrique.

Préférentiellement, les plages de valeurs sont croissantes dans le sens partant de l'âme 701 vers l'extérieur du câble. Alternativement, les plages de valeurs peuvent aussi être décroissantes dans le sens partant de l'âme 701 vers l'extérieur du câble.

Autrement dit, dans un mode de réalisation de l'invention, le diélectrique 702 est choisi pour être sensible à des doses de radiations comprises dans l'intervalle [a ;b], le diélectrique 703 est choisi pour être sensible à des doses de radiations comprises dans l'intervalle [b ;c], le diélectrique 704 est choisi pour être sensible à des doses de radiations comprises dans l'intervalle [c ;d], le diélectrique 705 est choisi pour être sensible à des doses de radiations comprises dans l'intervalle [d ;e], avec a<b<c<d<e.

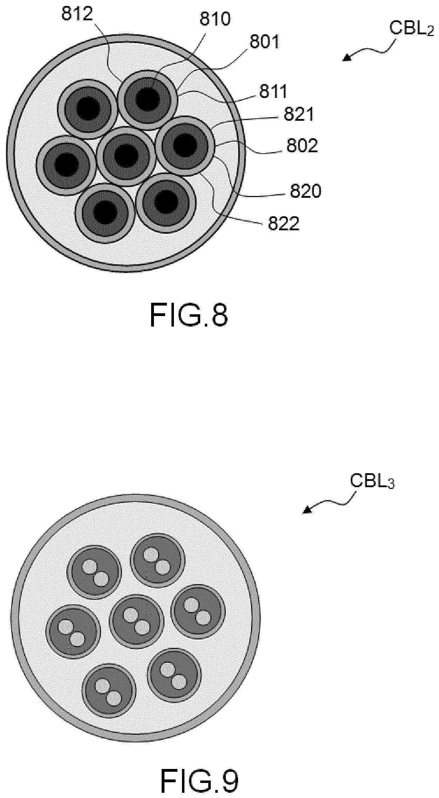

La figure 8 représente une autre variante de réalisation d'un câble CBL₂ ayant une structure parallèle. Le câble CBL₂ comporte plusieurs brins coaxiaux 801, 802, chacun étant composé d'une âme centrale 810, 820, d'un diélectrique 811, 821 et entouré d'un blindage isolant 812, 822.

Les différents diélectriques 811, 821 sont choisis de la même façon que pour le câble CBL₁ de la figure 7, c'est-à-dire qu'ils sont chacun sensibles à des plages de valeurs de doses de radiation différentes.

La figure 9 représente encore une autre variante de réalisation d'un câble CBL₃ ayant également une structure parallèle mais les brins coaxiaux de la figure 8 sont remplacés par des paires torsadées entourées par un diélectrique différent pour chaque paire.

Sans sortir du cadre de l'invention, d'autres architectures de câble sont envisageables dans la mesure où le câble conçu comporte plusieurs diélectriques ayant chacun des sensibilités aux rayonnements différents.

En particulier, une autre architecture de câble possible consiste à utiliser à la place de paires torsadées, des lignes bifilaires constituées de deux conducteurs parallèles.

La sensibilité d'un diélectrique aux radiations est mesurée en fonction de l'impact de ces radiations sur la grandeur physique mesurée à partir du réflectogramme ou de la mesure obtenue par transférométrie.

Un diélectrique est sensible à une dose de radiations dès que cette dose génère une discontinuité d'impédance qui modifie la valeur de la grandeur physique, par exemple l'impédance caractéristique, par rapport à une valeur de référence obtenue pour un câble non soumis à des radiations.

Les tests de réflectométrie ou de transférométrie sont réalisés en injectant un signal entre l'âme 701 du câble CBL1 ou de l'un des brins du câble CBL2 et l'un des blindages ou bien entre deux blindages différents. Lorsqu'un câble du type de ceux décrits à la figure 7 ou figure 8 est utilisé, plusieurs tests conduisant à plusieurs mesures sont réalisés pour chacun des diélectriques.

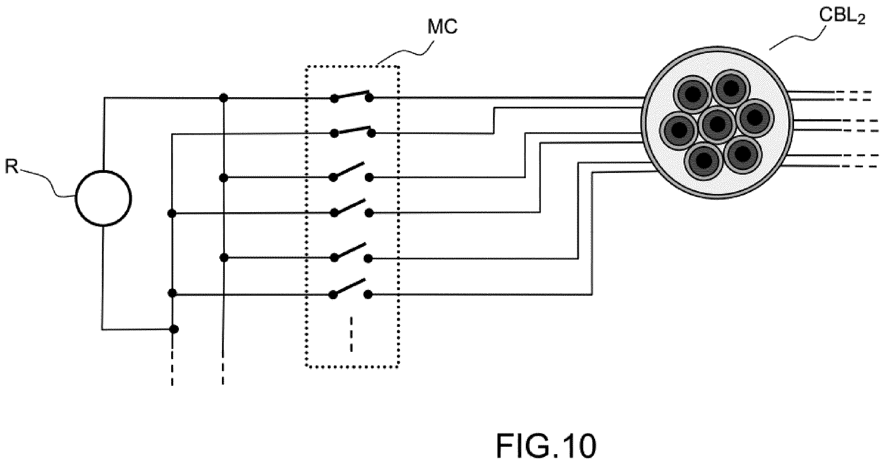

La figure 10 représente un exemple particulier de mise en œuvre du dispositif selon l'invention lorsque le câble présente une architecture complexe du type de celle de la figure 8.

Dans ce cas, le test de réflectométrie est mis en œuvre au moyen de matrices de commutation MC de signaux basées par exemple sur des relais électromagnétiques permettant d'aiguiller l'injection d'un signal de réflectométrie vers le bon couple de conducteurs. La matrice de commutation est reliée par ses entrées au réflectomètre R, c'est-à-dire au dispositif comprenant d'une part des moyens d'injection d'un signal dans un câble et d'autre part des moyens de mesure du signal rétro-propagé. D'autre part, chaque sortie de la matrice de commutation est reliée à un des brins coaxiaux 801, 802 du câble.

Pour les câbles simples, l'injection du signal de réflectométrie est réalisée entre les deux conducteurs électriques d'une paire torsadée ou entre l'âme et le blindage d'un coaxial.

Pour les câbles complexes, l'injection du signal est par exemple réalisée entre deux conducteurs électriques d'un même élément de base, i.e. les deux conducteurs d'une paire torsadée ou bien l'âme et le blindage d'un coaxial. Selon un autre exemple de réalisation, l'injection du signal est réalisée entre deux conducteurs électriques de deux éléments de base différents, par exemple un conducteur d'une paire torsadée avec un conducteur d'une autre paire ou bien l'âme d'un coaxial avec l'âme ou le blindage d'un autre coaxial. Cette vaste possibilité de configurations d'injection est cependant limitée en pratique par les capacités de la matrice de commutation à relais utilisée.

Dans un mode de réalisation particulier, le câble CBL du dispositif selon l'invention peut être fabriqué avec un diamètre très fin de façon à pouvoir être tissé afin de réaliser un tissu couvrant une surface. Ce tissu peut être utilisé pour recouvrir la surface d'un objet ou d'un appareil sur lequel on souhaite mesurer l'impact des radiations.

Avantageusement, l'utilisation de méthodes de réflectométrie ou de transférométrie permet également de localiser la zone du câble ou du tissu qui est irradiée en identifiant la signature temporelle de la discontinuité d'impédance générée par l'irradiation dans la mesure du signal.

Selon un autre aspect de l'invention, les isolants des câbles soumis à un taux de radiation trop élevé peuvent être régénérés lorsqu'ils sont trop endommagés de sorte à rétablir leur structure initiale. Par exemple, de tels isolants peuvent être conçus avec de la paraffine qui peut être chauffée afin de régénérer sa structure pour une nouvelle utilisation.

### Références

[1] Wane Yufen, Cao Xiaolong, Liu Yaonan, « Radiation Effects on Dielectric Properties of Dielectric Films », Conference Record of the 1994 IEEE International Symposium on Electrical Insulation, Pittsburgh, PA USA, June 5-8, 1994.
[2] Simone Vincenzo Suraci, Davide Fabiani, Konsta Sipilä, Harri Joki, « Filler impact analysis on aging of crosslinked polyethylene for nuclear applications through dielectric spectroscopy », 2020.
[3] Simone Vincenzo Suraci, Davide Fabiani, Laura Mazzocchetti and Loris Giorgini, « Degradation Assessment of Polyethylene-Based Material Through Electrical and Chemical-Physical Analyses », Energies 2020, 13, 650.
[4] S. Raghu, K. Archana, C. Sharanappa, S. Ganesh, H. Devendrappa, « Electron beam and gamma ray irradiated polymer electrolyte films: Dielectric properties », Journal of Radiation Research and Applied Sciences 9 (2016) 117-124.
[5] V. R. Sunitha,·S. Radhakrishnan, « Gamma irradiation effects on conductivity and dielectric behaviour of PEO-based nano-composite polymer electrolyte systems », Polymer Bulletin (2020) 77:655-670.

## Revendications

1. Dispositif (400) de mesure de dose de radiations reçue comprenant un câble (CBL,CBL₁,CBL₂, CBL₃) composé d'au moins un matériau sensible à une dose de radiations reçue dans au moins une plage de valeur prédéterminée et un équipement de mesure (GEN, INJ, MES) connecté au câble et configuré pour réaliser une mesure, par réflectométrie ou transférométrie, d'une grandeur physique caractéristique du câble, une base de données (BDM) comportant un ensemble de couples de valeurs associant une valeur de la grandeur physique à une valeur de dose de radiations reçue et une unité de traitement (UT) configurée pour déterminer une mesure de la dose de radiations reçue par le câble à partir de la mesure de la grandeur physique et en interrogeant la base de données (BDM).

2. Dispositif de mesure de dose de radiations selon la revendication 1 dans lequel l'équipement de mesure est configuré pour injecter un signal de test en un point du câble et mesurer ledit signal propagé ou réfléchi en un point du câble et déterminer une mesure de ladite grandeur physique à partir de la mesure du signal.

3. Dispositif de mesure de dose de radiations selon l'une quelconque des revendications précédentes dans lequel la grandeur physique est une amplitude d'un pic de désadaptation mesuré sur le signal ou un coefficient de réflexion ou une impédance caractéristique.

4. Dispositif de mesure de dose de radiations selon l'une quelconque des revendications précédentes dans lequel la grandeur physique est mesurée en une pluralité de points du câble et la mesure de dose de radiations est déterminée pour chacun de ces points.

5. Dispositif de mesure de dose de radiations selon l'une quelconque des revendications précédentes dans lequel l'unité de traitement (UT) est configurée pour réaliser une interpolation des valeurs de la base de données à partir de la mesure de la grandeur physique pour en déduire la mesure de dose de radiations.

6. Dispositif de mesure de dose de radiations selon l'une quelconque des revendications précédentes dans lequel la base de données (BDM) comporte plusieurs jeux de couples de valeurs pour différents types de matériaux et/ou différents types de rayonnements.

7. Dispositif de mesure de dose de radiations selon l'une quelconque des revendications précédentes dans lequel le câble (CBL₁,CBL₂, CBL₃) est composé de plusieurs diélectriques (702, 703, 704, 705) séparés par des blindages (710, 720, 730, 740), chaque diélectrique présentant une sensibilité au rayonnement dans des plages de dose de radiations différentes, l'équipement de mesure étant configuré pour réaliser une mesure de la grandeur physique pour chaque diélectrique.

8. Dispositif de mesure de dose de radiations selon la revendication 7 dans lequel le câble (CBL₁) présente une structure coaxiale et est composé de plusieurs diélectriques coaxiaux (702, 703, 704, 705) séparés par des blindages (710, 720, 730, 740).

9. Dispositif de mesure de dose de radiations selon la revendication 7 dans lequel le câble (CBL₂) présente une structure parallèle et est composé de plusieurs brins coaxiaux (801, 802) étant chacun composé d'une âme centrale (810, 820), d'un diélectrique (811, 821) et d'un blindage (812, 822).

10. Dispositif de mesure de dose de radiations selon la revendication 7 dans lequel le câble (CBL₃) présente une structure parallèle et est composé de plusieurs paires torsadées étant chacune entourée d'un diélectrique et d'un blindage.

11. Dispositif de mesure de dose de radiations selon l'une quelconque des revendications 7 à 10 comprenant en outre une matrice de commutations pour connecter l'équipement de mesure aux différents diélectriques du câble.

12. Tissu intelligent comprenant un dispositif de mesure de dose de radiations selon l'une quelconque des revendications précédentes dans lequel le câble est un fil conducteur tissé pour réaliser le tissu.

13. Procédé de calibration d'un dispositif de mesure de dose de radiations selon l'une quelconque des revendications 1 à 11 comprenant les étapes de :
- Irradier au moins une portion du câble avec une dose de radiations prédéterminée,
- Réaliser une mesure, par réflectométrie ou transférométrie, d'une grandeur physique caractéristique du câble,
- Sauvegarder dans une base de données le couple de valeurs de dose de radiations et de grandeur physique associée,
- Itérer les étapes précédentes pour différentes doses de radiations.

## Patentansprüche

1. Vorrichtung (400) zum Messen einer empfangenen Strahlungsdosis, umfassend ein Kabel (CBL, CBL₁, CBL₂, CBL₃), das aus mindestens einem Material besteht, das gegenüber einer empfangenen Strahlungsdosis in mindestens einem vorbestimmten Wertebereich empfindlich ist, und eine Messausrüstung (GEN, INJ, MES), die mit dem Kabel verbunden und so konfiguriert ist, dass sie eine Messung durch Reflektometrie oder Transferometrie einer charakteristischen physikalischen Größe des Kabels durchführt, eine Datenbank (BDM) mit einem Satz von Wertepaaren, die einen Wert der physikalischen Größe einem empfangenen Strahlungsdosiswert zuordnen, und eine Verarbeitungseinheit (UT), die so konfiguriert ist, dass sie anhand der Messung der physikalischen Größe und durch Abfragen der Datenbank (BDM) eine Messung der von dem Kabel empfangenen Strahlungsdosis bestimmt.

2. Vorrichtung zum Messen einer Strahlungsdosis nach Anspruch 1, wobei die Messausrüstung so konfiguriert ist, dass sie ein Testsignal an einem Punkt des Kabels einspeist und das ausgebreitete oder reflektierte Signal an einem Punkt des Kabels misst und eine Messung der physikalischen Größe anhand der Messung des Signals bestimmt.

3. Vorrichtung zum Messen einer Strahlungsdosis nach einem der vorhergehenden Ansprüche, wobei die physikalische Größe eine Amplitude einer Fehlanpassungsspitze, die an dem Signal gemessen wird, oder ein Reflexionskoeffizient oder eine charakteristische Impedanz ist.

4. Vorrichtung zum Messen einer Strahlungsdosis nach einem der vorhergehenden Ansprüche, wobei die physikalische Größe an einer Vielzahl von Punkten des Kabels gemessen wird und die Strahlungsdosismessung für jeden dieser Punkte bestimmt wird.

5. Vorrichtung zum Messen einer Strahlungsdosis nach einem der vorhergehenden Ansprüche, wobei die Verarbeitungseinheit (UT) so konfiguriert ist, dass sie anhand der Messung der physikalischen Größe eine Interpolation der Werte der Datenbank durchführt, um daraus die Strahlungsdosismessung abzuleiten.

6. Vorrichtung zum Messen einer Strahlungsdosis nach einem der vorhergehenden Ansprüche, wobei die Datenbank (BDM) mehrere Sätze von Wertepaaren für unterschiedliche Arten von Materialien und/oder unterschiedliche Arten von Strahlungen aufweist.

7. Vorrichtung zum Messen einer Strahlungsdosis nach einem der vorhergehenden Ansprüche, wobei das Kabel (CBL₁, CBL₂, CBL₃) aus mehreren Dielektrika (702, 703, 704, 705) besteht, die durch Abschirmungen (710, 720, 730, 740) getrennt sind, wobei jedes Dielektrikum eine Empfindlichkeit gegenüber Strahlung in unterschiedlichen Strahlungsdosisbereichen aufweist, wobei die Messausrüstung so konfiguriert ist, dass sie eine Messung der physikalischen Größe für jedes Dielektrikum durchführt.

8. Vorrichtung zum Messen einer Strahlungsdosis nach Anspruch 7, wobei das Kabel (CBL₁) eine koaxiale Struktur aufweist und aus mehreren koaxialen Dielektrika (702, 703, 704, 705) besteht, die durch Abschirmungen (710, 720, 730, 740) getrennt sind.

9. Vorrichtung zum Messen einer Strahlungsdosis nach Anspruch 7, wobei das Kabel (CBL₂) eine parallele Struktur aufweist und aus mehreren koaxialen Strängen (801, 802) besteht, die jeweils aus einem zentralen Kern (810, 820), einem Dielektrikum (811, 821) und einer Abschirmung (812, 822) bestehen.

10. Vorrichtung zum Messen einer Strahlungsdosis nach Anspruch 7, wobei das Kabel (CBL₃) eine parallele Struktur aufweist und aus mehreren verdrillten Paaren besteht, die jeweils von einem Dielektrikum und einer Abschirmung umgeben sind.

11. Vorrichtung zum Messen einer Strahlungsdosis nach einem der Ansprüche 7 bis 10, ferner umfassend eine Schaltmatrix, um die Messausrüstung mit den unterschiedlichen Dielektrika des Kabels zu verbinden.

12. Intelligentes Gewebe, umfassend eine Vorrichtung zum Messen einer Strahlungsdosis nach einem der vorhergehenden Ansprüche, wobei das Kabel ein leitfähiger Draht ist, das zum Herstellen des Gewebes gewebt wird.

13. Verfahren zum Kalibrieren einer Vorrichtung zum Messen einer Strahlungsdosis nach einem der Ansprüche 1 bis 11, folgende Schritte umfassend:
- Bestrahlen mindestens eines Abschnitts des Kabels mit einer vorbestimmten Strahlungsdosis,
- Durchführen einer Messung, durch Reflektometrie oder Transferometrie, einer charakteristischen physikalischen Größe des Kabels,
- Sichern des Wertepaars von Strahlungsdosis und zugeordneter physikalischer Größe in einer Datenbank,
- Wiederholen der vorhergehenden Schritte bei unterschiedlichen Strahlungsdosen.

## Claims

1. A device (400) for measuring a received radiation dose comprising a cable (CBL, CBL₁, CBL₂, CBL₃) made up of at least one material sensitive to a received radiation dose in at least one predetermined value range and measuring equipment (GEN, INJ, MES) connected to the cable and configured to take a measurement, by reflectometry or transferometry, of a characteristic physical quantity of the cable, a database (BDM) having a set of pairs of values associating a value of the physical quantity with a received radiation dose value, and a processing unit (UT) configured to determine a measurement of the radiation dose received by the cable based on the measurement of the physical quantity and by polling the database (BDM).

2. The device for measuring a radiation dose according to claim 1, wherein the measuring equipment is configured to inject a test signal at a point of the cable and to measure said propagated or reflected signal at a point of the cable and to determine a measurement of said physical quantity based on the measurement of the signal.

3. The device for measuring a radiation dose according to any one of the preceding claims, wherein the physical quantity is an amplitude of a mismatch peak measured on the signal or a reflection coefficient or a characteristic impedance.

4. The device for measuring a radiation dose according to any one of the preceding claims, wherein the physical quantity is measured at a plurality of points of the cable and the radiation dose measurement is determined for each of these points.

5. The device for measuring a radiation dose according to any one of the preceding claims, wherein the processing unit (UT) is configured to interpolate the values of the database based on the measurement of the physical quantity to deduce the radiation dose measurement therefrom.

6. The device for measuring a radiation dose according to any one of the preceding claims, wherein the database (BDM) has several sets of pairs of values for various types of materials and/or various types of radiation.

7. The device for measuring a radiation dose according to any one of the preceding claims, wherein the cable (CBL₁, CBL₂, CBL₃) is made up of several dielectrics (702, 703, 704, 705) separated by shields (710, 720, 730, 740), with each dielectric exhibiting sensitivity to radiation in various radiation dose ranges, with the measuring equipment being configured to take a measurement of the physical quantity for each dielectric.

8. The device for measuring a radiation dose according to claim 7, wherein the cable (CBL₁) has a coaxial structure and is made up of several coaxial dielectrics (702, 703, 704, 705) separated by shields (710, 720, 730, 740).

9. The device for measuring a radiation dose according to claim 7, wherein the cable (CBL₂) has a parallel structure and is made up of several coaxial strands (801, 802), each made up of a central core (810, 820), a dielectric (811, 821) and a shield (812, 822).

10. The device for measuring a radiation dose according to claim 7, wherein the cable (CBL₃) has a parallel structure and is made up of several twisted pairs, each surrounded by a dielectric and a shield.

11. The device for measuring a radiation dose according to any one of claims 7 to 10, further comprising a switching matrix for connecting the measuring equipment to the various dielectrics of the cable.

12. A smart fabric comprising a device for measuring a radiation dose according to any one of the preceding claims, wherein the cable is a conductive wire woven to produce the fabric.

13. A method for calibrating a device for measuring a radiation dose according to any one of claims 1 to 11, comprising the following steps of:
- irradiating at least one portion of the cable with a predetermined radiation dose,
- measuring, by reflectometry or transferometry, a characteristic physical quantity of the cable,
- saving the pair of radiation dose and associated physical quantity values in a database,
- repeating the preceding steps for different radiation doses.
